# EUROPÄISCHE PATENTSCHRIFT

(11) **EP 1 216 772 B1**
(45) Veröffentlichungstag und Bekanntmachung des Hinweises auf die Patenterteilung: **12.10.2005**
(21) Anmeldenummer: 01128199.5
(22) Anmeldetag: 28.11.2001
(51) Int. Cl.: B22D 19/00, B22D 27/04, C23C 14/34, B22D 7/02, B22D 19/08

(54) **Verfahren zur Herstellung eines Rohrtargets**
Method for producing a tubular sputtering target
Procédé de fabrication d'une cible de pulvérisation tubulaire

(30) Priorität: 19.12.2000 DE 10063383
(43) Veröffentlichungstag der Anmeldung: 26.06.2002
(73) Patentinhaber: W.C. Heraeus GmbH, 63450 Hanau (DE)
(72) Erfinder: Heck, Ralf, 63454 Hanau (DE); Jüttner, Rainer, 63594 Hasselroth (DE); Lupton, David Francis, Dr., 63571 Gelnhausen (DE); Maier, Egon, 63594 Hasselroth (DE); Mainz, Peter, 63549 Ronneburg (DE); Manhardt, Harald, 63486 Bruchköbel (DE); Stenger, Bernd, 63546 Hammersbach (DE); Zingg, Holger, 63599 Biebergemünd (DE)
(74) Vertreter: Kühn, Hans-Christian

(56) Entgegenhaltungen:
- EP-A- 0 092 477
- DE-A- 3 532 131

## Beschreibung

Die Erfindung betrifft ein Verfahren zur Herstellung eines Rohrtargets für Kathodenzerstäubungsanlagen, wobei das Rohrtarget aus einem metallischen Innenrohr aus einem ersten Material mit einem ersten Schmelzpunkt Tₛ₁ von ≥ 900 K und einem das Innenrohr konzentrisch umgebenden metallischen Außenrohr aus einem zweiten Material mit einem zweiten Schmelzpunkt Tₛ₂ von ≤ 800 K gebildet wird und wobei der Innendurchmesser des Außenrohres mit dem Außendurchmesser des Innenrohres formschlüssig und mechanisch fest verbunden wird. Die Erfindung betrifft weiterhin die Verwendung des Verfahrens.

Immer häufiger werden Rohrtargets beziehungsweise rotierende Targets gegenüber planaren Targets zur Herstellung dünner Schichten bevorzugt, da sie eine höhere Materialausbeute beim Abscheideprozess, auch Sputterprozess genannt, ermöglichen. Besonders vorteilhaft ist die Verwendung von Rohrtargets bei der Herstellung oxidischer dünner Schichten durch reaktives Sputtern von Metallen unter sauerstoffhaltigen Atmosphären. Dabei werden vorzugsweise die Oxide niedrigschmelzender Metalle wie Zinn, Zink, Indium, Wismut oder deren Legierungen als dünne Schichten abgeschieden. Diese niedrigschmelzenden Metalle neigen bereits bei Raumtemperatur oder bei den leicht erhöhten Temperaturen während des Sputterprozesses zum Kriechen. Das Kriechen tritt bei Temperaturen auf, die gleich oder höher 40 % der Schmelztemperatur des betreffenden Metalles betragen. Um eine Kriechverformung zu verhindern, werden Außenrohre aus solchen Metalle üblicherweise durch ein, meist gekühltes, Innenrohr aus einem höherschmelzenden Material gestützt. Dabei muss eine flächige Verbindung mit guter Haftfestigkeit hergestellt werden, um einen guten Wärmeübergang zu gewährleisten.

US 5,354,446 offenbart unterschiedliche Herstellungsverfahren für Rohrtargets mit einem Innenrohr beziehungsweise einem Targetstützrohr und einem Außenrohr beziehungsweise einem Targetrohr aus weichen, niedrigschmelzenden oder bruchanfälligen Metallen oder Legierungen.

Dabei wird einerseits ein Verfahren beschrieben, bei dem das Außenrohr durch thermisches Spritzen auf das Innenrohr aufgebracht wird. Ein weiteres Verfahren offenbart, das zylindrische Außenrohr durch ein Indium-Lot mit dem Innenrohr zu verbinden. Zudem wird die Verwendung von haftverbessernden Schichten zwischen Innen- und Außenrohr beschrieben, die eine Anpassung zwischen den unterschiedlichen Wärmeausdehnungskoeffizienten von Innen- und Außenrohr herstellen. Weiterhin wird ein Verfahren beschrieben, bei dem das Außenrohr durch heißisostatisches Pressen auf das Innenrohr aufgebracht wird.
Die genannten Verfahren sind aufwendig, zum Teil problematisch und kostenintensiv. So ist das vollflächige Verbinden von Innen- und Außenrohr durch Löten generell aufgrund der geometrischen Verhältnisse schwierig. Besonders schwierig gestaltet sich dieses Verfahren aber dann, wenn ein Außenrohr aus niedrigschmelzendem Material gelötet werden soll, da die Schmelzpunkte von Außenrohr und Lot oft in sehr ähnlichen Bereichen liegen.
Beim Auftrag des Außenrohrs durch thermisches Spritzen ergeben sich Unregelmäßigkeiten im Gefüge des Außenrohres. Diese Unregelmäßigkeiten sind einmal durch Gaseinschlüsse in Form von Poren, Gaseinschlüsse in gelöster Form oder durch Einschlüsse von Oxidpartikeln in metallischen Spritzschichten gegeben. Durch den prozesstechnisch beim thermischen Spritzen erforderlichen Auftrag in Schichten entsteht zudem im Außenrohr ein ungleichmäßiges Gefüge mit Schalenaufbau, wobei die Haftung am Innenrohr schlecht ist. Solche Gefügestörungen äußern sich im Kathodenzerstäubungsvorgang in ungleichmäßigen Abscheideraten. Gaseinschlüsse in Poren können zu Verpuffungen und Materialabplatzungen führen, da die Kathodenzerstäubung unter Vakuum erfolgt. Im Gefüge gelöster Sauerstoff beeinflusst und erschwert die Einstellung der Stöchiometrie bei der Abscheidung eines Oxids.

Auch die Herstellung von zylindrischen Metallrohren durch Gießen ist bekannt. So offenbaren DE 24 27 098, DE 35 32 131 A1 und DE 42 16 870 A1 jeweils Gießverfahren zur Herstellung von Metallteilen mit Hilfe von Gießkokillen, wobei eine gerichtete Erstarrung der Metallschmelze angestrebt wird, um ein möglichst gleichmäßiges, gerichtetes Gefüge herzustellen. Die gerichtete Erstarrung der Metallschmelze wird durch Abkühlung in einem gerichteten Temperaturfeld erreicht, wobei die Gießkokille von unten nach oben abgekühlt wird. Der Temperaturgradient wird beispielsweise dadurch erreicht, dass die Gießkokille in ein Tauchbad gesenkt, mit Luft gekühlt oder mit Heizelementen umgeben wird.
EP 092 477 offenbart den senkrechten Hohlguss eines Stahlblocks in einer Gießkokille, wobei ein gekühlter, metallischer Hohldom verwendet wird. In den Hohldom wird zum Kühlen Gas oder Nebel eingeleitet, wobei das Gas oder der Nebel vom Kokillenboden aus entlang des Hohldoms in Richtung der Oberseite der Gießkokille strömt. Der Hohldom haftet nach dem Abkühlen der Kokille am Stahlblock, ohne dass eine metallische Verbindung zwischen den beiden ausgebildet wird, wie sie bei einem Verschweißen oder Verlöten entstehen würde. Damit wird ein Durchbruch beziehungsweise ein Durchschmelzen des Hohldorns beim Gießen sowie die Bildung von Warmrissen im gegossenen Stahlblock vermieden.

Es stellt sich das Problem, ein einfaches und kostengünstiges Verfahren zur Herstellung von Rohrtargets für Kathodenzerstäubungsanlagen bereitzustellen, mit dem in einem zu zerstäubenden Außenrohr mit einem Schmelzpunkt ≤ 800 K eine hohe Reinheit und ein gerichtetes Gefüge erzeugt werden kann. Es stellt sich weiterhin das Problem, eine Verwendung für ein solches Verfahrens anzugeben.

Das Problem wird dadurch gelöst, dass das Außenrohr durch Gießen des zweiten Materials in schmelzflüssigem Zustand in eine zylindrische, senkrecht stehende beheizte Gießkokille gebildet wird, wobei die Gießkokille einen beheizten Dom aufweist, der aus dem Innenrohr gebildet wird, und dass nach Befüllen eines Raumes zwischen Gießkokille und Innenrohr mit dem schmelzflüssigen zweiten Material ein erster Temperaturgradient zwischen Innenrohr und Gießkokille ausgebildet wird, dass ein zweiter Temperaturgradient zwischen Unter- und Oberseite der Gießkokille ausgebildet wird und dass das Außenrohr gleichzeitig von innen nach außen und von unten nach oben abgekühlt wird.
Dieses Verfahren hat den Vorteil, dass eine ausreichende Nachspeisung des Gussteils erfolgen kann und damit eine Lunkerbildung minimiert wird. Eingeschlossene Gasblasen können nach oben aus der Gießkokille entweichen. Es entsteht ein gerichtetes, sehr gleichmäßiges und sauberes Gefüge mit stengeligen Kristalliten, wobei die Stengel senkrecht zur Oberfläche des Außenrohrs angeordnet sind. Zudem wird zwischen dem Außen- und dem Innenrohr eine metallische Verbindung erzeugt, die in einer hohen Haftfestigkeit und einem idealen Wärmeübergang resultiert.
Vorzugsweise wird das zweite Material unter Inertgas oder im Vakuum erschmolzen und anschließend über eine Flüssigmetallpumpe oder einen Siphon in die Gießkokille transportiert, um die Bildung von Oxiden beziehungsweise Verunreinigungen so weit wie möglich zu unterdrücken.
Der zweite Temperaturgradient wird vorzugsweise dadurch ausgebildet, dass die Gießkokille durch mindestens zwei getrennt regelbare, die Gießkokille jeweils radial umschließende Heizvorrichtungen beheizt wird. Dabei ist es von Vorteil, als Heizvorrichtungen elektrische Heizmatten zu verwenden. Solche Heizmatten sind aus Heizleitern, eingebettet in ein isolierendes Material, gebildet und durch ihre Flexibilität formschlüssig um die Gießkokille zu legen.
Das Innenrohr wird vorzugsweise über seinen Innendurchmesser mit heißem Gas oder Dampf geheizt.
Gießkokille und Innenrohr werden dabei bevorzugt auf eine Temperatur im Bereich von 400 K bis 850 K vorgeheizt, bevor der Gießprozess beginnt. Das Vorheizen verhindert ein zu rasches Erstarren der Schmelze an der Innenwandung der Gießkokille und der Außenwand des Innenrohrs, das zu Unregelmäßigkeiten im Gefüge des Außenrohres führen würde. Besonders bewährt hat sich dabei, zumindest die Gießkokille auf eine Temperatur vorzuheizen, die größer als der Schmelzpunkt T_{S2} des zweiten Materials ist, so dass beim Befüllen eine Erstarrung der Schmelze an der Innenwandung der Gießkokille vollständig vermieden wird.

Als erstes Material haben sich Edelstahl, Aluminium oder Kupfer bewährt. Die Schmelzpunkte dieser Materialien sind signifikant höher als die des zweiten Materials um während des Gießvorganges ein Durchschmelzen des Innenrohres auszuschließen.

Als zweites Material wird bevorzugt Zinn, Zink, Wismut, Indium oder eine Legierung aus diesen verwendet.

Um die Ausbildung der metallischen Verbindung zwischen dem Außen- und den Innenrohr zu verbessern, kann das Innenrohr vor dem Gießen vorbehandelt werden, indem auf seinem Außendurchmesser eine Haftvermittlerschicht mit einer Dicke im Bereich von 5 µm bis 500 µm aufgetragen wird.
Dazu kann unter Verwendung eines Flussmittels eine Lotschicht als Haftvermittlerschicht aufgetragen werden, die Haftvermittlerschicht zumindest teilweise durch galvanische oder stromlose Abscheidung hergestellt oder durch thermisches Spritzen hergestellt werden.

Es hat sich bewährt, ein Innenrohr aus Edelstahl zu verwenden und als Haftvermittlerschicht unter Verwendung des Flussmittels die Lotschicht aufzutragen, wobei die Lotschicht zumindest teilweise aus dem zweiten Material gebildet ist.
Weiterhin hat es sich bewährt, ein Innenrohr aus Aluminium oder Kupfer zu verwenden und die Haftvermittlerschicht zumindest teilweise durch galvanische oder stromlose Abscheidung herzustellen, wobei die Haftvermittlerschicht zumindest teilweise aus dem zweiten Material gebildet ist. Nach einer galvanischen oder stromlosen Abscheidung kann hier zusätzlich das Aufbringen einer Lotschicht sinnvoll sein. Außerdem hat es sich bewährt, die Haftvermittlerschicht durch thermisches Spritzen von insbesondere Nickel herzustellen.

Der erste Temperaturgradient wird idealerweise dadurch erzeugt, dass die Beheizung des Innendurchmessers des Innenrohres abgeschaltet wird. Zusätzlich hat es sich bewährt, den Innendurchmesser des Innenrohres mit kaltem Gas oder Dampf anzuströmen.
Der zweite Temperaturgradient wird vorzugsweise dadurch erzeugt, dass die mindestens zwei Heizvorrichtungen zeitlich verzögert abgeschaltet werden. Dazu wird zuerst die Heizvorrichtung in Nähe des Bodens der Gießkokille und nachfolgend die mindestens eine, daran angrenzende weitere Heizvorrichtung in Richtung der Oberseite der Gießkokille abgeschaltet. Pro 30 cm bis 50 cm Gießkokillenlänge sollte dabei eine separat regelbare Heizvorrichtung vorgesehen sein, um einen sanften Verlauf des zweiten Temperaturgradienten zu erzeugen.

Um das Rohrtarget nach dem Abkühlen leicht aus der Gießkokille entnehmen zu können, sollte diese radial aus mindestens zwei Teilen gebildet sein.

Mit dem erfindungsgemäßen Verfahren werden vorzugsweise Außenrohre mit einer Dicke im Bereich von 3 mm bis 12 mm hergestellt.

Die Verwendung des Verfahren zur Herstellung eines Rohrtargets für Kathodenzerstäubungsanlagen mit einem Sauerstoffgehalt im Außenrohr von ≤ 100 ppm und einem Gefüge, das sich aus Stengelkristalliten zusammensetzt, die senkrecht zur Oberfläche des Außenrohres angeordnet sind, ist ideal.
Vorzugsweise wird das Verfahren verwendet, um einen Sauerstoffgehalt von ≤ 50 ppm beziehungsweise eine mittlere Korngröße der Stengelkristallite von 0.3 mm bis 15 mm einzustellen.

Folgende Ausführungs- und Vergleichsbeispiele sowie die Figurendarstellung sollen den Erfindungsgedanken beispielhaft erläutern.
- Beispiel 1:: Herstellung eines Rohrtargets mit einem Außenrohr aus Zinn und einem Innenrohr aus Edelstahl
- Beispiel 2:: Herstellung eines Rohrtargets mit einem Außenrohr aus Zink und einem Innenrohr aus Edelstahl
- Vergleichsbeispiel:: Herstellung eines Rohrtargets mit einem Außenrohr aus Zink durch thermisches Spritzen
- Figur 1:: Gießvorrichtung zur Durchführung des erfindungsgemäßen Verfahrens mit einer Gießkokille mit geschlossenem Boden
- Figur 2:: Gießvorrichtung zur Durchführung des erfindungsgemäßen Verfahrens mit einer Gießkokille mit einer Öffnung im Boden

### Beispiel 1:

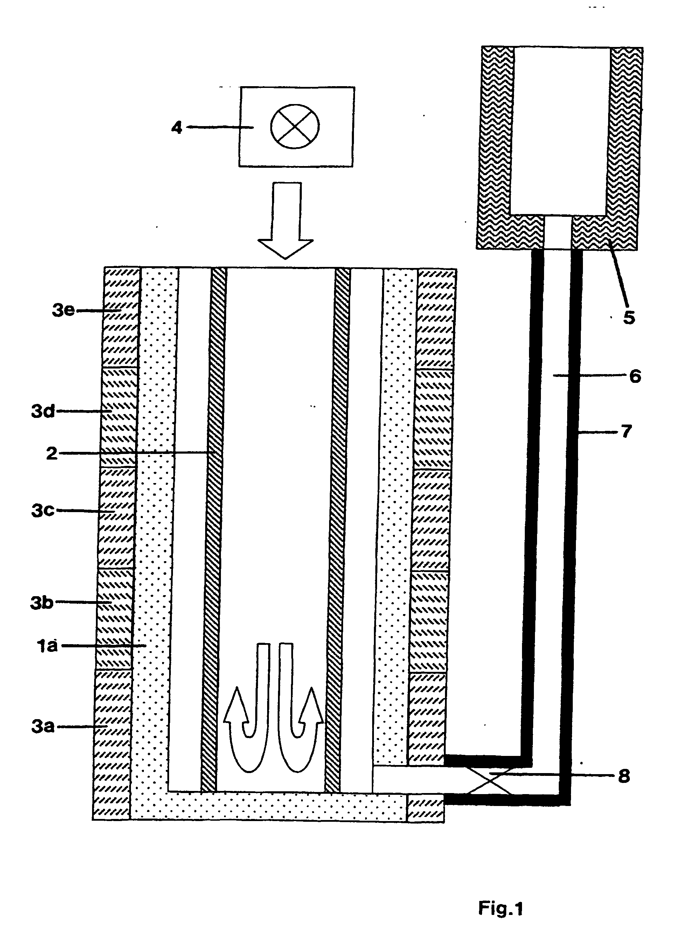

Ein Innenrohr aus Edelstahl (Innendurchmesser 127 mm, Außendurchmesser 133 mm, Länge 1500 mm) wird auf seinem Außendurchmesser mittels eines handelsüblichen Flussmittels mit Zinn belotet. Das belotete Innenrohr wird zentrisch in einer zweiteiligen Gießkokille angeordnet. Die Gießkokille ist von außen durch Heizmatten auf ca. 300 °C beheizt, das Innenrohr wird an seinem Innendurchmesser durch ein Heißluftgebläse ebenfalls auf ca. 300 °C erwärmt. In einem Schmelztiegel, der durch einen Siphon (siehe auch Fig. 1) mit der Gießkokille verbunden ist, wird Zinn mit 99.99 %-iger Reinheit unter Argon-Atmosphäre erschmolzen. Das erschmolzene Zinn wird über eine beheizte Rohrleitung in die Gießkokille geleitet und diese im Raum zwischen Innenrohr und Gießkokille bis zur Oberkante gefüllt. Nun wird das Heißluftgebläse abgeschaltet und vom Boden der Gießkokille beginnend die Heizmatten nacheinander abgeschaltet und entfernt. Durch Nachspeisung von erschmolzenem Zinn am oberen Ende der Gießkokille wird ein Absinken des Metallspiegels verhindert. Nach dem Abkühlen und vollständigen Erstarren des Zinns und Ausbildung des Außenrohres in einer Dicke von 14 mm wurde die Gießkokille entfernt und das Außenrohr überdreht, um eine gleichmäßige Oberfläche zu erreichen. Außerdem wurde die Länge des Außenrohres auf 1350 mm eingestellt, wobei das Innenrohr aus Edelstahl an beiden Enden freigelegt wurde.
Nachuntersuchungen des Gefüges des Rohrtargets ergaben, dass sich stengelige Zinn-Kristallite mit einer mittleren Korngröße von 8 mm senkrecht zur Oberfläche des Außenrohres gebildet hatten, die sowohl über ihre Länge als auch ihren Umfang sehr gleichmäßig waren. Der Sauerstoffgehalt des Zinns betrug nach dem LECO-Heißextraktionsverfahren 7 ppm. Einschlüsse, Poren oder Lunker konnten im Zinn nicht festgestellt werden. Eine Ultraschalluntersuchung zeigte, dass die Haftung des Außenrohres am Innenrohr ausgezeichnet war.

### Beispiel 2:

Ein Innenrohr aus Edelstahl (Innendurchmesser 127 mm, Außendurchmesser 133 mm, Länge 1500 mm) wird auf seinem Außendurchmesser mittels eines handelsüblichen Flussmittels mit Zink belotet. Das belotete Innenrohr wird zentrisch in einer zweiteiligen Gießkokille angeordnet. Die Gießkokille ist von außen durch Heizmatten auf ca. 500 °C beheizt, das Innenrohr wird an seinem Innendurchmesser durch ein Heißluftgebläse ebenfalls auf ca. 500 °C erwärmt. In einem Schmelztiegel, der durch einen Siphon (siehe auch Fig. 1) mit der Gießkokille verbunden ist, wird Zink unter Argon-Atmosphäre erschmolzen. Das erschmolzene Zink wird über eine beheizte Rohrleitung in die Gießkokille geleitet und diese im Raum zwischen Innenrohr und Gießkokille bis zur Oberkante gefüllt. Nun wird das Heißluftgebläse abgeschaltet und vom Boden der Gießkokille beginnend die Heizmatten nacheinander abgeschaltet und entfernt. Durch Nachspeisung von erschmolzenem Zink am oberen Ende der Gießkokille wird ein Absinken des Metallspiegels verhindert. Nach dem Abkühlen und vollständigen Erstarren des Zinks wurde die Gießkokille entfernt und das Rohrtarget wie in Beispiel 1 bearbeitet.
Nachuntersuchungen des Gefüges des Rohrtargets ergaben, dass sich stengelige Zink-Kristallite mit einer mittleren Korngröße von 1.7 mm senkrecht zur Oberfläche des Außenrohres gebildet hatten, die sowohl über ihre Länge als auch ihren Umfang sehr gleichmäßig waren. Der Sauerstoffgehalt des Zinns betrug nach dem LECO-Heißextraktionsverfahren 20 ppm. Einschlüsse, Poren oder Lunker konnten im Zinn nicht festgestellt werden. Eine Ultraschalluntersuchung zeigte, dass die Haftung des Außenrohres am Innenrohr ausgezeichnet war.

### Vergleichsbeispiel:

Ein Zink-Draht mit einem Durchmesser von 3.1 mm und einem Sauerstoffgehalt von 28 ppm nach dem LECO-Heißextraktionsverfahren wurde durch Flammspritzen unter Argon-Atmosphäre schichtweise (je Schicht ca. 0.1 mm) auf ein Innenrohr aus Edelstahl aufgebracht. Das erzeugte Außenrohr aus Zink hatte eine Dicke von 10 mm.
Nachuntersuchungen des Gefüge des Rohrtargets ergaben, dass sich zwischen den nacheinander aufgetragenen Zink-Schichten mit einer Dicke von je ca. 0.1 mm viele oxidische Einschlüsse mit einem Durchmesser von je ca. 0.02 mm befanden. Auch wurde eine große Anzahl von Poren im Außenrohr festgestellt. Einzelne Kristallite konnten im metallographischen Schliff trotz einer 200 fachen Vergrößerung nicht gefunden werden. Ein Sauerstoffgehalt im Zink unter 2500 ppm (LECO-Heißextraktionsverfahren) konnte trotz wiederholter Versuche und Verbesserungsmaßnahmen nicht erreicht werden.

Fig. 1 zeigt eine zylindrische, senkrecht stehende Gießkokille 1a und ein in der Gießkokille 1a zentrisch angeordnetes Innenrohr 2. Die Gießkokille 1a ist von elektrischen Heizmatten 3a, 3b, 3c, 3d, 3e umgeben. Ein Heißluftgebläse 4 ist zur Erwärmung des Innenrohres 2 vorgesehen, wobei die heiße Luft am Boden der Gießkokille 1a zurück in Richtung des Heißluftgebläses 4 gelenkt wird. Ein Schmelztiegel 5 zur Aufnahme des zu erschmelzenden zweiten Materials ist oberhalb der Oberkante der Gießkokille 1a angeordnet und über einen Siphon beziehungsweise eine Rohrleitung 6 mit dem Raum zwischen Gießkokille 1a und dem Innenrohr 2 verbunden. Der Siphon beziehungsweise die Rohrleitung 6 ist durch Heizbänder 7 beheizt, um ein Abkühlen oder Erstarren des erschmolzenen zweiten Materials auf seinem Weg vom Schmelztiegel 5 in die Gießkokille 1a zu verhindern. Ein Ventil 8 zwischen Siphon beziehungsweise Rohrleitung 6 und Gießkokille 1a ermöglicht ein gezieltes Befüllen des Raumes zwischen Gießkokille 1a und Innenrohr 2.

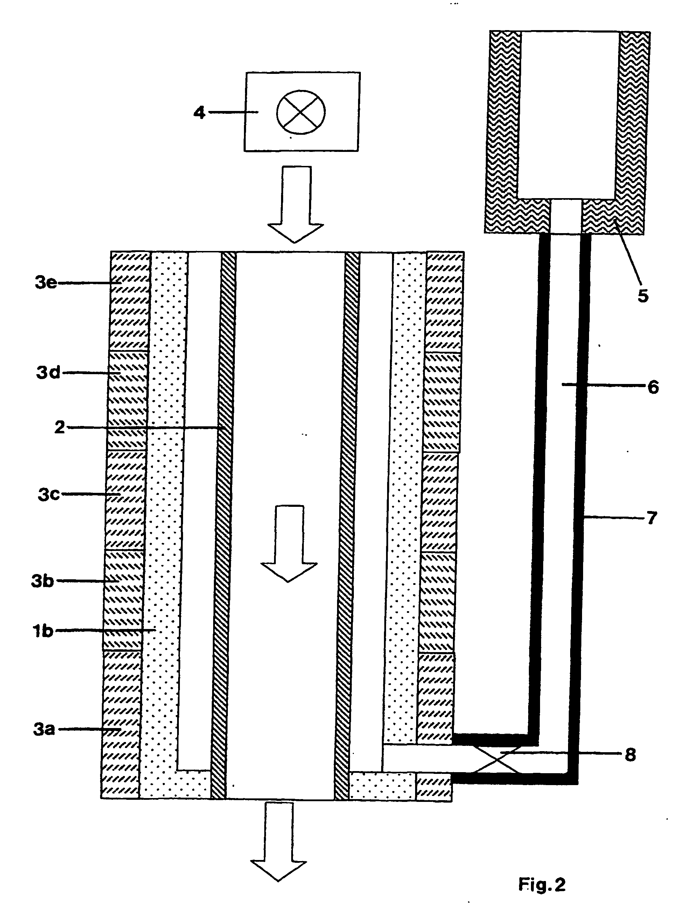

Fig. 2 zeigt eine zylindrische, senkrecht stehende Gießkokille 1 b und ein in der Gießkokille 1 b zentrisch angeordnetes Innenrohr 2. Die Gießkokille 1 ist von elektrischen Heizmatten 3a, 3b, 3c, 3d, 3e umgeben. Ein Heißluftgebläse 4 ist zur Erwärmung des Innenrohres 2 vorgesehen. Hier ist das Innenrohr 2 durch eine Öffnung im Boden der Gießkokille 1b geführt, so dass die heiße Luft dort entweicht. Ein Schmelztiegel 5 zur Aufnahme des zu erschmelzenden zweiten Materials ist oberhalb der Oberkante der Gießkokille 1b angeordnet und über einen Siphon beziehungsweise eine Rohrleitung 6 mit dem Raum zwischen Gießkokille 1b und dem Innenrohr 2 verbunden. Der Siphon beziehungsweise die Rohrleitung 6 ist durch Heizbänder 7 beheizt, um ein Abkühlen oder Erstarren des erschmolzenen zweiten Materials auf seinem Weg vom Schmelztiegel 5 in die Gießkokille 1b zu verhindern. Ein Ventil 8 zwischen Siphon beziehungsweise Rohrleitung 6 und Gießkokille 1b ermöglicht ein gezieltes Befüllen des Raumes zwischen Gießkokille 1b und Innenrohr 2.

## Patentansprüche

1. Verfahren zur Herstellung eines Rohrtargets für Kathodenzerstäubungsanlagen, wobei das Rohrtarget aus einem metallischen Innenrohr (2) aus einem ersten Material mit einem ersten Schmelzpunkt Tₛ₁ von ≥ 900 K und einem das Innenrohr konzentrisch umgebenden metallischen Außenrohr aus einem zweiten Material mit einem zweiten Schmelzpunkt Tₛ₂ von ≤ 800 K gebildet wird und wobei der Innendurchmesser des Außenrohres mit dem Außendurchmesser des Innenrohres formschlüssig und mechanisch fest verbunden wird, **dadurch gekennzeichnet, dass** das Außenrohr durch Gießen des zweiten Materials in schmelzflüssigem Zustand in eine zylindrische, senkrecht stehende beheizte Gießkokille (1a) gebildet wird, wobei die Gießkokille einen beheizten Dorn aufweist, der aus dem Innenrohr (2) gebildet wird, und dass nach Befüllen eines Raumes zwischen Gießkokille und Innenrohr mit dem schmelzflüssigen zweiten Material ein erster Temperaturgradient zwischen Innenrohr und Gießkokille ausgebildet wird, dass ein zweiter Temperaturgradient zwischen Unter- und Oberseite der Gießkokille ausgebildet wird und dass das Außenrohr gleichzeitig von innen nach außen und von unten nach oben abgekühlt wird.

2. Verfahren nach Anspruch 1, **dadurch gekennzeichnet, dass** die Gießkokille durch mindestens zwei getrennt regelbare, die Gießkokille jeweils radial umschließende Heizvorrichtungen beheizt wird.

3. Verfahren nach Anspruch 2, **dadurch gekennzeichnet, dass** als Heizvorrichtungen elektrische Heizmatten verwendet werden.

4. Verfahren nach mindestens einem der Ansprüche 1 bis 3, **dadurch gekennzeichnet, dass** das Innenrohr über seinen Innendurchmesser mit heißem Gas oder Dampf beheizt wird.

5. Verfahren nach mindestens einem der Ansprüche 1 bis 4, **dadurch gekennzeichnet, dass** die Gießkokille und das Innenrohr auf eine Temperatur im Bereich von 400 K bis 850 K vorgeheizt werden.

6. Verfahren nach Anspruch 5, **dadurch gekennzeichnet, dass** zumindest die Gießkokille auf eine Temperatur größer dem Schmelzpunkt T_{S2} des zweiten Materials vorgeheizt wird.

7. Verfahren nach mindestens einem der Ansprüche 1 bis 6, **dadurch gekennzeichnet, dass** als erstes Material Edelstahl, Aluminium oder Kupfer verwendet wird.

8. Verfahren nach mindestens einem der Ansprüche 1 bis 7, **dadurch gekennzeichnet, dass** als zweites Material Zinn, Zink, Wismut, Indium oder eine Legierung aus diesen verwendet wird.

9. Verfahren nach mindestens einem der Ansprüche 1 bis 8, **dadurch gekennzeichnet, dass** das Innenrohr vor dem Gießen vorbehandelt wird, indem auf seinem Außendurchmesser eine Haftvermittlerschicht mit einer Dicke im Bereich von 5 µm bis 500 µm aufgetragen wird.

10. Verfahren nach Anspruch 9, **dadurch gekennzeichnet, dass** unter Verwendung eines Flussmittels eine Lotschicht als Haftvermittlerschicht aufgetragen wird.

11. Verfahren nach Anspruch 9, **dadurch gekennzeichnet, dass** die Haftvermittlerschicht zumindest teilweise durch galvanische oder stromlose Abscheidung hergestellt wird.

12. Verfahren nach Anspruch 9, **dadurch gekennzeichnet, dass** die Haftvermittlerschicht durch thermisches Spritzen hergestellt wird.

13. Verfahren nach den Ansprüchen 8, 9 und 10, **dadurch gekennzeichnet, dass** ein Innenrohr aus Edelstahl verwendet wird, dass als Haftvermittlerschicht unter Verwendung des Flussmittels die Lotschicht aufgetragen wird und dass die Lotschicht zumindest teilweise aus dem zweiten Material gebildet ist.

14. Verfahren nach den Ansprüchen 8, 9 und 11, **dadurch gekennzeichnet, dass** ein Innenrohr aus Aluminium oder Kupfer verwendet wird, dass die Haftvermittlerschicht zumindest teilweise durch galvanische oder stromlose Abscheidung hergestellt wird und dass die Haftvermittlerschicht zumindest teilweise aus dem zweiten Material gebildet ist.

15. Verfahren nach Anspruch 12, **dadurch gekennzeichnet, dass** die Haftvermittlerschicht durch thermisches Spritzen von Nickel hergestellt wird.

16. Verfahren nach mindestens einem der Ansprüche 1 bis 15, **dadurch gekennzeichnet, dass** der erste Temperaturgradient **dadurch** erzeugt wird, dass die Beheizung des Innendurchmessers des Innenrohres abgeschaltet wird.

17. Verfahren nach Anspruch 16, **dadurch gekennzeichnet, dass** der erste Temperaturgradient **dadurch** erzeugt wird, dass der Innendurchmesser des Innenrohres mit kaltem Gas oder Dampf angeströmt wird.

18. Verfahren nach mindestens einem der Ansprüche 2 bis 17, **dadurch gekennzeichnet, dass** der zweite Temperaturgradient **dadurch** erzeugt wird, dass die mindestens zwei Heizvorrichtungen zeitlich verzögert abgeschaltet werden.

19. Verfahren nach mindestens einem der Ansprüche 1 bis 18, **dadurch gekennzeichnet, dass** die Gießkokille radial aus mindestens zwei Teilen gebildet ist.

20. Verfahren nach mindestens einem der Ansprüche 1 bis 19, **dadurch gekennzeichnet, dass** das Außenrohr mit einer Dicke im Bereich von 3 mm bis 12 mm hergestellt wird.

21. Verwendung des Verfahrens nach einem der Ansprüche 1 bis 20 zur Herstellung eines Rohrtargets für Kathodenzerstäubungsanlagen mit einem Sauerstoffgehalt im Außenrohr von ≤ 100 ppm und einem Gefüge, das sich aus Stengelkristalliten zusammensetzt, die senkrecht zur Oberfläche des Außenrohres angeordnet sind.

22. Verwendung nach Anspruch 21, **dadurch gekennzeichnet, dass** der Sauerstoffgehalt ≤ 50 ppm beträgt.

23. Verwendung nach einem der Ansprüche 21 bis 22, **dadurch gekennzeichnet, dass** die mittlere Korngröße der Stengelkristallite 0.3 mm bis 15 mm beträgt.

## Claims

1. Process for the production of a tube target for cathode sputtering installations wherein the tube target is formed by a metallic inner tube (2) consisting of a first material with a first melting point Tₛ₁ of not less than 900 K and a metallic outer tube concentrically surrounding the inner tube and consisting of a second material with a second melting point Tₛ₂ of not more than 800 K and wherein the inner diameter of the outer tube is positively and mechanically fixedly joined to the outer diameter of the inner tube, **characterized in that** the outer tube is formed by pouring the second material in a molten state into a cylindrical, upright, heated casting-mould (1a), this mould having a heated core which is formed by the inner tube (2), and **in that** after a space between mould and inner tube has been filled with the molten second material a first temperature gradient is established between inner tube and mould, a second temperature gradient is established between the bottom and top of the mould, and the outer tube is cooled simultaneously from the inside outwards and from the bottom upwards.

2. Process according to Claim 1, **characterized in that** the casting-mould is heated by at least two separately controllable heating devices each radially surrounding the mould.

3. Process according to Claim 2, **characterized in that** electric heating pads are used as heating devices.

4. Process according to at least one of Claims 1 to 3, **characterized in that** the inner tube is heated with hot gas or vapour over its internal diameter.

5. Process according to at least one of Claims 1 to 4, **characterized in that** the casting-mould and inner tube are preheated to a temperature in the range of 400 K to 850 K.

6. Process according to Claim 5, **characterized in that** the casting-mould at least is preheated to a temperature above the melting point Tₛ₂ of the second material.

7. Process according to at least one of Claims 1 to 6, **characterized in that** stainless steel, aluminium or copper is used as the first material.

8. Process according to at least one of Claims 1 to 7, **characterized in that** tin, zinc, bismuth, indium or an alloy of these is used as the second material.

9. Process according to at least one of Claims 1 to 8, **characterized in that** the inner tube is pretreated before pouring, by coating its outer diameter with a bonding-promoter layer with a thickness in the range of 5 µm to 500 µm.

10. Process according to Claim 9, **characterized in that** a layer of solder is applied, with the use of a flux, as the bonding-promoter layer.

11. Process according to Claim 9, **characterized in that** the bonding-promoter layer is produced at least in part by electroplating or electroless plating.

12. Process according to Claim 9, **characterized in that** the bonding-promoter layer is produced by thermal spraying.

13. Process according to Claims 8, 9 and 10, **characterized in that** a stainless steel inner tube is used, the layer of solder is applied, with the use of a flux, as the bonding-promoter layer, and the solder layer is formed at least in part by the second material.

14. Process according to Claims 8, 9 and 11, **characterized in that** an aluminium or copper inner tube is used, the bonding-promoter layer is produced at least in part by electroplating or electroless plating, and the bonding-promoter layer is formed at least in part by the second material.

15. Process according to Claim 12, **characterized in that** the bonding-promoter layer is produced by thermal spraying of nickel.

16. Process according to at least one of Claims 1 to 15, **characterized in that** the first temperature gradient is produced by switching off the heating of the inner diameter of the inner tube.

17. Process according to Claim 16, **characterized in that** the first temperature gradient is produced by passing cold gas or vapour over the inner diameter of the inner tube.

18. Process according to at least one of Claims 2 to 17, **characterized in that** the second temperature gradient is produced by switching off the at least two heating devices with a time lag.

19. Process according to at least one of Claims 1 to 18, **characterized in that** the casting-mould is radially formed from at least two parts.

20. Process according to at least one of Claims 1 to 19, **characterized in that** the outer tube is made with a thickness in the range of 3 mm to 12 mm.

21. Use of the process according to any one of Claims 1 to 20 for the production of a tube target for cathode sputtering installations with an acid content in the outer tube of not more than 100 ppm and with a grain structure which is composed of columnar crystallites arranged perpendicularly to the surface of the outer tube.

22. Use according to Claim 21, **characterized in that** the acid content is not more than 50 ppm.

23. Use according to Claim 21 or Claim 22, **characterized in that** the mean grain size of the columnar crystallites is 0.3 mm to 15 mm.

## Revendications

1. Procédé de fabrication d'une cible tubulaire pour des installations de pulvérisation cathodique, dans lequel la cible tubulaire est formée par un tube intérieur métallique (2) en un premier matériau avec un premier point de fusion T_{S1} ≥ 900 K et par un tube extérieur métallique entourant concentriquement le tube intérieur, en un deuxième matériau avec un deuxième point de fusion T_{S2} ≤ 800 K, et dans lequel le diamètre intérieur du tube extérieur est relié de manière solidaire mécaniquement et par coopération de formes avec le diamètre extérieur du tube intérieur, **caractérisé en ce que** le tube extérieur est formé en coulant le deuxième matériau à l'état liquide en fusion dans une coquille de coulée (1a) cylindrique, chauffée et dressée debout, la coquille de coulée présentant un mandrin chauffé qui est formé par le tube intérieur (2), et **en ce qu'**après avoir rempli un espace entre la coquille de coulée et le tube intérieur avec le deuxième matériau liquide en fusion, on établit un premier gradient de température entre le tube intérieur et la coquille de coulée, **en ce qu'**on établit un deuxième gradient de température entre la face inférieure et la face supérieure de la coquille de coulée, et **en ce que** le tube extérieur est refroidi simultanément depuis l'intérieur vers l'extérieur et depuis le bas vers le haut.

2. Procédé selon la revendication 1, **caractérisé en ce que** la coquille de coulée est chauffée par au moins deux dispositifs de chauffage séparément réglables et entourant chacun radialement la coquille de coulée.

3. Procédé selon la revendication 2, **caractérisé en ce qu'**on utilise en tant que dispositifs de chauffage des nappes de chauffage électriques.

4. Procédé selon au moins l'une des revendications 1 à 3, **caractérisé en ce que** le tube intérieur est chauffé sur son diamètre intérieur par du gaz chaud ou de la vapeur chaude.

5. Procédé selon au moins l'une des revendications 1 à 4, **caractérisé en ce que** la coquille de coulée et le tube intérieur sont préchauffés à une température dans la plage de 400 K à 850 K.

6. Procédé selon la revendication 5, **caractérisé en ce qu'**au moins la coquille de coulée est préchauffée à une température supérieure au point de fusion T_{S2} du deuxième matériau.

7. Procédé selon au moins l'une des revendications 1 à 6, **caractérisé en ce qu'**on utilise comme premier matériau de l'acier inoxydable, de l'aluminium ou du cuivre.

8. Procédé selon au moins l'une des revendications 1 à 7, **caractérisé en ce qu'**on utilise comme deuxième matériau de l'étain, du zinc, du bismuth, de l'indium ou un alliage de ceux-ci.

9. Procédé selon au moins l'une des revendications 1 à 8, **caractérisé en ce que** le tube intérieur est soumis à un traitement préalable avant la coulée en appliquant sur son diamètre extérieur une couche d'agent adhésif avec une épaisseur dans la plage de 5 µm à 500 µm.

10. Procédé selon la revendication 9, **caractérisé en ce qu'**on applique une couche de métal d'apport de brasage servant de couche d'agent adhésif, en utilisant un agent de fluxage.

11. Procédé selon la revendication 9, **caractérisé en ce que** la couche d'agent adhésif est réalisée au moins partiellement par déposition galvanique ou sans courant.

12. Procédé selon la revendication 9, **caractérisé en ce que** la couche d'agent adhésif est réalisée par projection thermique.

13. Procédé selon les revendications 8, 9 et 10, **caractérisé en ce qu'**on utilise un tube intérieur en acier inoxydable, **en ce qu'**on applique la couche de métal d'apport de brasage servant de couche d'agent adhésif, en utilisant un agent de fluxage, et **en ce que** la couche de métal d'apport de brasage est formée au moins partiellement par le deuxième matériau.

14. Procédé selon les revendications 8, 9 et 11, **caractérisé en ce qu'**on utilise un tube intérieur en aluminium ou en cuivre, **en ce que** la couche d'agent adhésif est réalisée au moins partiellement par déposition galvanique ou sans courant, et **en ce que** la couche d'agent adhésif est formée au moins partiellement par le deuxième matériau.

15. Procédé selon la revendication 12, **caractérisé en ce que** la couche d'agent adhésif est réalisée par projection thermique de nickel.

16. Procédé selon au moins l'une des revendications 1 à 15, **caractérisé en ce que** le premier gradient de température est produit en arrêtant le chauffage du diamètre intérieur du tube intérieur.

17. Procédé selon la revendication 16, **caractérisé en ce que** le premier gradient de température est produit en faisant passer un gaz froid ou de la vapeur froide à travers le diamètre intérieur du tube intérieur.

18. Procédé selon au moins l'une des revendications 2 à 17, **caractérisé en ce que** le deuxième gradient de température est produit en arrêtant lesdits au moins deux dispositifs de chauffage avec retardement dans le temps.

19. Procédé selon au moins l'une des revendications 2 à 18, **caractérisé en ce que** la coquille de coulée est formée radialement par au moins deux parties.

20. Procédé selon au moins l'une des revendications 1 à 19, **caractérisé en ce que** le tube extérieur est réalisé avec une épaisseur dans la plage de 3 mm à 12 mm.

21. Utilisation du procédé selon l'une des revendications 1 à 20 pour la fabrication d'une cible tubulaire pour des installations de pulvérisation cathodique avec un taux d'oxygène dans le tube extérieur ≤ 100 ppm et une structure qui est composée par des cristallites prismatiques qui sont agencés perpendiculairement à la surface du tube extérieur.

22. Utilisation selon la revendication 21, **caractérisé en ce que** le taux d'oxygène est ≤ 50 ppm.

23. Utilisation selon l'une des revendications 21 à 22, **caractérisé en ce que** la granulométrie moyenne des cristallites prismatiques est de 0,3 mm à 15 mm.
